(19) Europäisches Patentamt
European Patent Office
Office européen des brevets

(11) **EP 3 366 506 B1**

(12) **EUROPÄISCHE PATENTSCHRIFT**

(45) Veröffentlichungstag und Bekanntmachung des Hinweises auf die Patenterteilung:
**28.12.2022 Patentblatt 2022/52**

(21) Anmeldenummer: **18154942.9**

(22) Anmeldetag: **02.02.2018**

(51) Internationale Patentklassifikation (IPC):
**B60L 3/00** (2019.01)     **B60L 50/51** (2019.01)
**B60L 58/10** (2019.01)     **G01R 27/02** (2006.01)
**G01R 31/52** (2020.01)

(52) Gemeinsame Patentklassifikation (CPC):
**G01R 31/52; B60L 3/0069; B60L 50/51; B60L 58/10;** B60L 2240/526; B60L 2260/44; G01R 27/025; Y02T 10/70

(54) **TECHNIK ZUR ISOLATIONSÜBERWACHUNG IN FAHRZEUGEN**

TECHNIQUE FOR INSULATION MONITORING IN VEHICLES

TECHNIQUE DE SURVEILLANCE DE L'ISOLEMENT DES VÉHICULES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.02.2017 DE 102017001849**

(43) Veröffentlichungstag der Anmeldung:
**29.08.2018 Patentblatt 2018/35**

(73) Patentinhaber: **MAN Truck & Bus SE**
**80995 München (DE)**

(72) Erfinder:
• **Mörtl, Alexander**
**82110 Germering (DE)**
• **Hubert, Markus**
**81247 München (DE)**
• **Soboll, Stefan**
**85221 Dachau (DE)**

(74) Vertreter: **v. Bezold & Partner Patentanwälte - PartG mbB**
**Ridlerstraße 57**
**80339 München (DE)**

(56) Entgegenhaltungen:
**EP-A1- 1 930 737      EP-A1- 2 709 255**
**DE-A1-102016 103 883   JP-A- 2003 250 201**
**US-A1- 2016 163 127    US-A1- 2016 181 965**
**US-B1- 8 168 315**

**EP 3 366 506 B1**

**Beschreibung**

Die vorliegende Erfindung betrifft eine Technik zur Bestimmung von Isolationswiderständen. Insbesondere sind eine Vorrichtung zur Bestimmung von Isolationswiderständen in einem Kraftfahrzeug und ein mit einer solchen Vorrichtung ausgestattetes Kraftfahrzeug beschrieben.

Kraftfahrzeuge mit elektrifiziertem Antriebsstrang besitzen ein Gleichstromnetz, das die elektrische Energie eines Traktionsenergiespeichers (beispielsweise einer Antriebsbatterie oder einer Brennstoffzelle) an elektrischen Aggregate verteilt, insbesondere an die elektrische Antriebseinheit des Antriebsstrangs und Nebenaggregate des Kraftfahrzeuges. Die elektrischen Aggregate werden in der Regel nicht mit der Gleichspannung des Gleichstromnetzes versorgt, sondern mit Wechselstrom, mehrphasigem Drehstrom, gepulster Gleichspannung oder einer Gleichspannung mit einer vom Gleichstromnetz abweichenden Spannung. Deshalb sind Stromrichter zwischen dem Gleichstromnetz und den jeweiligen Aggregaten angeordnet. Die Stromrichter haben dabei die Aufgabe, den Gleichstrom des Gleichstromnetzes in das jeweilige Stromprofil umzuformen und umgekehrt, beispielsweise zur Rekuperation von Bewegungsenergie des Kraftfahrzeuges. Somit liegen gekoppelte Gleich- und Wechselstromnetze vor.

Aufgrund des hohen Leistungsbedarfs für den elektrischen Antrieb wird das Gleichstromnetz und die daraus gespeisten Wechselstromnetze häufig als Hochspannungsnetz (beispielsweise mit Spannungen zwischen 300 Volt und 1000 Volt) bzw. IT-Netz (*frz.* Isole Terre) ausgeführt. Um die elektrische Sicherheit insbesondere für Fahrzeuginsassen beim Betrieb zu gewährleisten, wird der Isolationswiderstand des Stromnetzes gegenüber der elektrischen Masse überwacht. Sinkt der Isolationswiderstand aufgrund von Isolationsfehlern ab, kann ein Nutzer des Kraftfahrzeugs gewarnt werden, beispielsweise um Maßnahmen zur Reparatur des Netzes frühzeitig zu ergreifen.

Herkömmlicherweise ist die Isolationsüberwachung an das Gleichstromnetz des Kraftfahrzeugs elektrisch angebunden, beispielsweise innerhalb der Antriebsbatterie. Im Stand der Technik sind Einrichtungen zur Isolationsüberwachung verbreitet, welche ein passives Messverfahren einsetzen, da diese Einrichtungen sehr kostengünstig sind. Hierbei wird die im Gleichstromnetz vorhandene Gleichspannungsquelle eingesetzt, um einen Messstrom zwischen dem Gesamtnetz und der elektrischen Masse zu treiben. Aus dem sich einstellenden Messstrom kann nach bekannten Verfahren der Isolationswiderstand des Gesamtnetzes gegenüber der elektrischen Masse bestimmt werden.

Jedoch ist das Passivmessverfahren mit Anbindung an das Gleichstromnetz ungenau und häufig systematisch falsch, da der Isolationswiderstand des über die Stromrichter angekoppelten Wechselstromnetzes nicht wertrichtig bestimmt wird. Der sich aufgrund des Isolationswiderstands des Wechselstromnetzes einstellende Messstrom wird durch den Betrieb der Stromrichter verringert und üblicherweise zeitvariabel verändert. Somit ist der mit einer herkömmlichen Überwachungseinrichtung vom Gleichstromnetz her gemessene Isolationswiderstand des Wechselstromnetzes meist deutlich höher als der tatsächliche Wert des Isolationswiderstands. Somit besteht die Gefahr, dass ein im Betrieb im Wechselstromnetz auftretender Isolationsfehler nicht erkannt wird. Zusammenfassend sind herkömmliche Einrichtungen nach dem passiven Messverfahren im Gleichstromnetz nicht geeignet zur Überwachung von galvanisch angekoppelten Wechselstromnetzen.

Aktive Messverfahren, bei denen ein zeitlich kodiertes Spannungssignal den Messstrom treibt, der durch einen Lock-in-Verstärker gemessen wird, sind im Vergleich zum passiven Messverfahren kostenintensiv und aufgrund ihrer Komplexität fehleranfälliger.

Das Dokument EP 1 930 737 A1 beschreibt ein Verfahren zur Messung eines kombinierten Isolationswiderstands, in dem aus dem an einer Pulsweitenmessvorrichtung gemessenen Verhältnis von Zeitwerten über- und unterhalb eines Schwellenwerts ein Tastgrad eines Hochspannungssystems berechnet wird, welcher mittels einer gespeicherten Beziehung in einen Wert des kombinierten Isolationswiderstands umgerechnet wird.

Das Dokument US 2016/163127 A1 beschreibt ein Verfahren zur Diagnose von Lecks elektronischer Fahrzeugteile, indem der Isolationswiderstand zwischen Batterie und Fahrgestell in jedem Fahrzustand, inklusive vor und nach der Fahrt, gemessen wird.

Das Dokument US 2016/181965 A1 beschreibt eine Motorantriebsschaltung mit einer Versorgungsleitung, die mit einer Gleichstromquelle verbunden ist, einem Wechselrichter, dessen Eingangsseite mit der Versorgungsleitung verbunden ist und dessen Ausgangsseite mit einem Motor verbunden ist, einem in die Versorgungsleitung eingefügter Leistungsschalter zum Umschalten der Versorgungsleitung zwischen Leit- und Abschaltzuständen, einem Spannungsdetektor zum Erfassen einer Spannung zwischen der Gleichstromquelle und dem Leistungsschalter, und einem Isolationswiderstandsdetektor zum Erfassen eines Isolationswiderstands.

Das Dokument DE 10 2010 054 413 A1 beschreibt ein Verfahren zum Lokalisieren eines Isolationsfehlers in einem System, das einen Gleichstromabschnitt und einen Wechselstromabschnitt einschließlich eines Wechselrichters aufweist. Der Wechselrichter umfasst Leistungsschalter, die jeweils während eines Messintervalls dauerhaft offen (Freilauf) und dauerhaft geschlossen (Durchschaltzustand) sind. Da solche Schaltzustände im Betrieb des Kraftfahrzeugs nicht vorkommen und ohne Einschränkung des Fahrzeugbetriebs auch nicht umsetzbar sind, ist dieses Verfahren im Fahrzeugbetrieb nicht einsetzbar.

Somit besteht die Aufgabe, eine Technik zur Bestimmung von Isolationswiderständen gekoppelter Gleich- und

2

Wechselstromnetze im Betrieb anzugeben.

Diese Aufgabe wird durch eine Vorrichtung zur Bestimmung von Isolationswiderständen in einem Kraftfahrzeug und einem Kraftfahrzeug mit den Merkmalen der unabhängigen Ansprüche gelöst. Vorteilhafte Ausführungen und Anwendungen sind Gegenstand der abhängigen Ansprüche und werden im Folgenden unter teilweiser Bezugnahme auf die Figuren näher erläutert.

Gemäß einem ersten Aspekt umfasste eine Vorrichtung zur Bestimmung von Isolationswiderständen in einem Kraftfahrzeug eine Erfassungseinrichtung, die dazu ausgebildet ist, in mindestens zwei Messintervallen jeweils einen Betriebszustand mindestens eines mit einem Traktionsenergiespeicher leitend verbundenen Stromrichters des Kraftfahrzeugs zu erfassen; eine Messeinrichtung mit einem Messanschluss, der mit mindestens einem Gleichspannungspol des elektrischen Traktionsenergiespeichers des Kraftfahrzeugs leitend verbunden oder verbindbar ist, und mit einem Masseanschluss, der mit einem Bezugspotential des Kraftfahrzeugs leitend verbunden oder verbindbar ist, wobei die Messeinrichtung dazu ausgebildet ist, in den mindestens zwei Messintervallen jeweils einen Leitwert zwischen dem Messanschluss und dem Masseanschluss zu messen; und eine Berechnungseinrichtung, die dazu ausgebildet ist, die Isolationswiderstände als Funktion der mindestens zwei gemessenen Leitwerte und der mindestens zwei erfassten Betriebszustände zu bestimmen.

Hierbei kann die Bestimmung eines Leitwerts äquivalent durch eine Bestimmung des Widerstands realisiert sein. Dabei können Leitwert und Widerstand reziprok zueinander sein.

Der Traktionsenergiespeicher kann eine Vielzahl von Zellmodulen zu Speicherung elektrischer Energie umfassen. Der Traktionsenergiespeicher kann ferner einen Zwischenkreis und/oder einen Spannungszwischenkreisumrichter umfassen. Der Spannungszwischenkreisumrichter kann eingangsseitig mit den Zellmodulen verbunden sein. Der Umrichter kann ausgangsseitig mit dem Zwischenkreis verbunden sein. Der Gleichspannungspol kann ein ausgangsseitiger Pol des Zwischenkreises sein.

Die Messung des Leitwerts kann durch die Messung eines Gesamtwiderstands realisiert sein. Die Messeinrichtung kann im jeweiligen Messintervall Strom und Spannung zwischen dem Messanschluss und dem Masseanschluss messen, wobei der Leitwert oder der Gesamtwiderstand aus dem gemessenen Strom und der gemessenen Spannung (beispielsweise als Verhältnis) berechnet werden (beispielsweise von der Messeinrichtung oder der Berechnungseinrichtung).

Erfindungsgemäß umfasst der Betriebszustand einen Tastgrad mindestens eines Schaltelementes des Stromrichters. Der Betriebszustand kann ferner einen Schaltzustand mindestens eines Schaltelementes des Stromrichters umfassen. Der Betriebszustand kann durch einen Kopplungsfaktor (beispielsweise eine reelle Zahl zwischen 0 und 1) repräsentiert werden. Der bestimmte Isolationswiderstand kann (beispielsweise bei durch die Messung gegebenem Leitwert) eine streng monoton fallende Funktion des Tastgrads oder des Kopplungsfaktors sein. Beispielsweise kann der Kehrwert des Isolationswiderstands linear sowohl im gemessenen Leitwert als auch dem Tastgrad bzw. Kopplungsfaktor sein. Alternativ kann der Isolationswiderstand linear sowohl zum gemessenen Widerstand (d.h. dem Kehrwert des Leitwerts) als auch dem inversen Tastgrad bzw. Kopplungsfaktors sein.

Der erfasste Tastgrad kann unter 100% und/oder über 0%, beispielsweise über 10%, sein. Der dem erfassten Tastgrad entsprechende Kopplungsfaktor (beispielsweise bei einer multiplikativen Verknüpfung der Kopplungsfaktoren mit den jeweiligen Leitwerten) kann unter 1 und über 0, beispielsweise über 0,1, sein. Der dem erfassten Tastgrad entsprechende Kopplungsfaktor (beispielsweise bei einer multiplikativen Verknüpfung der Kopplungsfaktoren mit den jeweiligen Widerständen) kann größer als 1, und optional kleiner als 10, sein. Der erfasste Tastgrad kann größer als ein Mindestwert (beispielsweise 5%, 10% oder 20%) sein.

Jeder der erfassten Betriebszustände kann im jeweiligen Messintervall zeitlich konstant sein. Die Kombination (oder Zusammensetzung) der in jedem Messintervall erfassten Betriebszustände kann in jedem Messintervall verschieden sein. Alternativ oder ergänzend bestimmt die Erfassungseinrichtung für einen sich im jeweiligen Messintervall zeitlich veränderten Betriebszustand einen zeitlich gemittelten Zustand. Der zeitlich gemittelte Zustand wird in der Berechnungseinrichtung der Bestimmung der Isolationswiderstände zugrunde gelegt.

Erfindungsgemäß umfasst der mindestens eine Stromrichter einen Wechselrichter und/oder einen Gleichspannungswandler. Jeder der Stromrichter kann Feldeffekttransistoren als Schaltelemente umfassen.

Der mindestens eine Stromrichter kann jeweils ein Aggregat des Kraftfahrzeugs speisen oder von diesem elektrische Energie ins Gleichstromnetz zurückleiten. Das Aggregat kann eine E-Maschine (Antrieb und/oder Generator) umfassen.

Das Bezugspotential kann eine elektrisch leitende Karosserie des Kraftfahrzeugs umfassen. Durch Faserverbundwerkstoffe elektrisch getrennte Karosserieteile können durch Masseleitungen elektrisch verbunden sein.

Erfindungsgemäß ist die Erfassungseinrichtung dazu ausgebildet, die Betriebszustände mehrerer Stromrichter jeweils in mehreren Messintervallen zu erfassen. Die Messeinrichtung ist dazu ausgebildet, in jedem der Messintervalle den Leitwert zu messen. Die Berechnungseinrichtung ist dazu ausgebildet, für jeden der Stromrichter (oder jedes Schaltelement) einen Isolationswiderstand aufgrund der gemessenen Leitwerte und der erfassten Betriebszustände und einer Anzahl der Messintervalle, die größer oder gleich der Anzahl der Stromnetze ist, zu berechnen.

Einer der Stromrichter (beispielsweise ein Wechselrichter) kann mit einer elektrischen Maschine zum Antrieb des Kraftfahrzeugs leitend verbunden sein. Alternativ oder ergänzend kann einer der Stromrichter (beispielsweise ein Gleichspannungswandler) mit einem elektrischen Antrieb einer Servolenkung des Kraftfahrzeugs leitend verbunden sein. Alternativ oder ergänzend kann einer der Stromrichter (beispielsweise ein Gleichspannungswandler oder Umrichter) mit einem Kompressor oder einer Pumpe des Kraftfahrzeugs leitend verbunden sein, beispielsweise dem Kompressor einer Klimaanlage, dem Kompressor zur Verdichtung von Luft oder der Ölpumpe einer Hydraulik des Kraftfahrzeugs.

Die Funktion kann Parameter oder Kopplungsfaktoren zur Gewichtung einer Abhängigkeit des Isolationswiderstands vom erfassten Betriebszustand umfassen. Die Berechnungseinrichtung kann einen Speicher umfassen, in dem Kraftfahrzeug-spezifische Werte der Parameter gespeichert sind. Die Funktion kann Parameter oder Kopplungsfaktoren zur Gewichtung einer linearen Abhängigkeit und/oder einer nichtlinearen Abhängigkeit des Isolationswiderstands vom erfassten Betriebszustand umfassen.

Die Erfassungseinrichtung kann die Messintervalle abhängig von einem Fahrzustand des Kraftfahrzeugs bestimmen. Die Erfassungseinrichtung kann mindestens ein Messintervall bestimmen, in dem mindestens einer der oder alle Betriebszustände zeitlich konstant sind.

Gemäß einem weiteren Aspekt ist ein Kraftfahrzeug bereitgestellt, das eine Vorrichtung gemäß dem vorstehenden Aspekt umfasst. Das Kraftfahrzeug kann einen elektrischen Traktionsenergiespeicher, mindestens einen mit dem Traktionsenergiespeicher leitend verbundenen Stromrichter und die Vorrichtung zum Bestimmen von Isolationswiderständen im Kraftfahrzeug umfassen.

Das Kraftfahrzeug kann ein Nutzfahrzeug, beispielsweise ein Lastkraftwagen oder eine Zugmaschine (zur Güterbeförderung) und/oder ein Bus (zur Personenbeförderung), oder ein Personenkraftwagen sein.

Vorstehend beschriebene Merkmale sind in jeder Kombination realisierbar. Weitere Merkmale und Vorteile der Erfindung werden im Folgenden unter Bezugnahme auf die beigefügten Zeichnungen beschrieben. Es zeigen:

Figur 1     eine schematische Darstellung eines Kraftfahrzeugs hinsichtlich seines Stromnetzes mit einem ersten Ausführungsbeispiel einer Vorrichtung zur Bestimmung von Isolationswiderständen im Kraftfahrzeug;

Figur 2     ein schematisches Blockschaltbild eines zweiten Ausführungsbeispiels der Vorrichtung zur Bestimmung von Isolationswiderständen im Kraftfahrzeug; und

Figur 3     ein schematisches Ersatzschaltbild zur Berechnung der Isolationswiderstände, die in einem der Ausführungsbeispiele der Vorrichtung implementierbar ist.

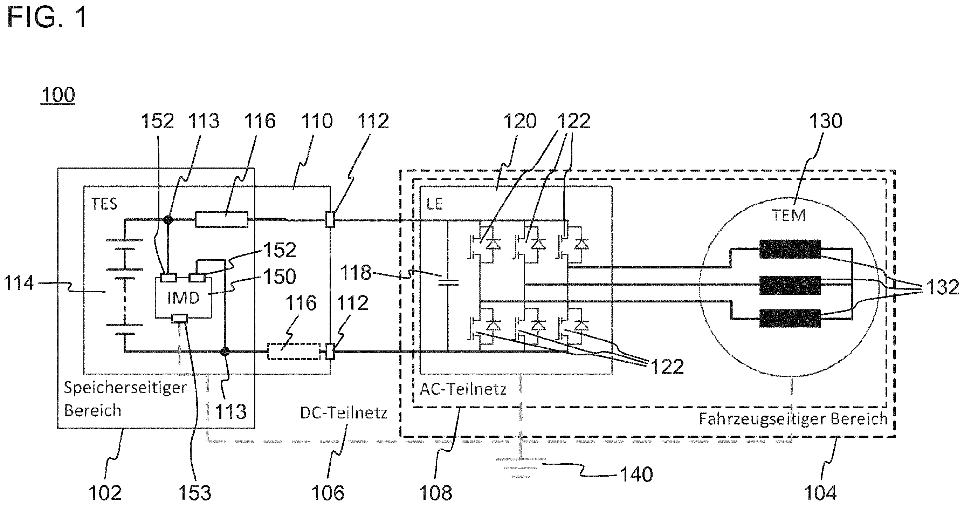

Figur 1 zeigt schematisch ein Beispiel eines allgemein mit Bezugszeichen 100 bezeichneten Kraftfahrzeugs, in dem die vorliegende Technik einsetzbar ist. Das Kraftfahrzeug 100 umfasst einen energiespeicherseitigen Bereich 102 und einen fahrzeugseitigen Bereich 104. Der energiespeicherseitige Bereich 102 und der fahrzeugseitige Bereich 104 sind durch ein Gleichstromnetz 106 verbunden, an das im fahrzeugseitigen Bereich 104 mindestens ein Wechselstromnetz 108 abgekoppelt ist. Typischerweise wird mindestens ein Wechselstromnetz 108 aus dem Gleichstromnetz 106 gespeist. Die gekoppelten Stromnetze 106 und 108 werden auch als Gesamtnetz bezeichnet und können als IT-Netz ausgebildet sein.

Das Kraftfahrzeug 100 umfasst einen Traktionsenergiespeicher 110 zur Speicherung elektrischer Energie. Diese wird über Gleichspannungspole 112 an das Gleichstromnetz 106 abgegeben (und gegebenenfalls bei einer Energierückgewinnung im Traktionsenergiespeicher 110 aufgenommen). Der Traktionsenergiespeicher 110 umfasst eine Vielzahl elektrochemischer Zellen, die in Zellmodulen 114 zusammengeschaltet sind und über ein Schaltschütz 116 schaltbar mit den Gleichspannungspolen 112 verbunden sind.

Ferner umfasst das Kraftfahrzeug 100 im fahrzeugseitigen Bereich 104 mindestens einen mit dem Traktionsenergiespeicher 110 elektrisch leitend verbundenen Stromrichter 120, der jeweils mindestens ein Aggregat 130 des Kraftfahrzeugs 100 im jeweiligen Wechselstromnetz 108 speist. Hierzu umfasst der Stromrichter 120 Schaltelemente 122, die jeweils eingangsseitig mit dem Traktionsenergiespeicher 110 und ausgangsseitig mit dem jeweiligen Aggregat 130 des Kraftfahrzeugs 100 verbunden sind. Typischerweise ist zwischen den Zellmodulen 114 als primäre Spannungsquelle und der Eingangsseite der Schaltelemente 122 ein Zwischenkreis 118 geschaltet, der Teil des Traktionsenergiespeichers 110, eigenständiger Teil des Gleichstromnetzes 106 oder (wie in Figur 1 gezeigt) Teil des Stromrichters 120 sein kann.

Das in Figur 1 gezeigte Aggregat 130 umfasst eine elektrische Antriebsmaschine (auch Traktions-E-Maschine oder TEM) des Kraftfahrzeugs 100, die als mehrphasige Drehstrommaschine ausgeführt ist. Die jeweiligen Phasen 132 werden von jeweils zwei als Halbbrücken geschalteten Schaltelementen 122 angesteuert. Das in Figur 1 gezeigte mehrphasige Wechselstromnetz 108 ist lediglich beispielhaft. Die Technik kann mit jedem Stromprofil, beispielsweise einphasigem Wechselstrom und/oder durch Pulsweitenmodulation (*engl.* "Pulse Width Modulation" oder PWM) gesteuerter Gleichspannung eingesetzt werden. Insbesondere kann das Kraftfahrzeug 100 aus dem Gleichstromnetz 106 mehrere Wechselstromnetze 108 speisen, die beispielsweise jeweils unterschiedliche Stromprofile für unterschiedliche Aggregate 130 bereitstellen.

Einem Betriebszustand des Stromrichters 120 gemäß nehmen dessen Schaltelemente 122 einen (im Allgemeinen dynamischen) Schaltzustand an. Die Schaltelemente 122 haben dabei die Aufgabe, den vom Gleichstromnetz 106 entnommenen Gleichstrom in einen entsprechend geformten Wechselstrom des Wechselstromnetzes 108 umzuformen und ggf. umgekehrt, beispielsweise zur Rekuperation. Vorzugsweise umfassen die Schaltelemente 122 schaltende Halbleiterelemente, die im Betrieb des Kraftfahrzeugs 100 gemäß einem (im Allgemeinen zeitabhängigen) Schaltzustand mit hohen Schaltfrequenzen, beispielsweise mindestens 1 kHz, angesteuert werden.

Der Schaltzustand ist beispielsweise durch einen Tastgrad (auch: Taktverhältnis) bestimmt. Der Tastgrad der Schaltelemente 122 ist ein Beispiel für einen Parameter des Betriebszustands des Stromrichters 120. Dabei ist der Tastgrad das Verhältnis von Impulsdauer bei geschlossenem Schaltelement 122 zur Periodendauer des dynamischen Schaltzustands (d.h., der reziproken Schaltfrequenzen).

Zur Bestimmung von Isolationswiderständen der Stromnetze 106 und 108 gegenüber einer elektrischen Masse 140 des Kraftfahrzeugs 100, beispielsweise dem durch einen metallischen Fahrzeugrahmen definierten Bezugspotential, umfasst das Kraftfahrzeug 100 eine Vorrichtung 150 zur Bestimmung von Isolationswiderständen im Kraftfahrzeug 100. Die Vorrichtung 150 kann auch als "Insulation Monitoring Device" (IMD) bezeichnet werden.

Das in Figur 1 gezeigte erste Ausführungsbeispiel der Vorrichtung 150 umfasst mindestens einen Messanschluss 152, der mit mindestens einem Gleichspannungspol 112 oder 113 eines elektrischen Traktionsenergiespeichers 110 leitend verbunden ist. Ferner umfasst die Vorrichtung 150 einen Masseanschluss 153, der mit einem Bezugspotential 140 des Kraftfahrzeugs 100 leitend verbunden ist.

Die Vorrichtung 150 kann, beispielsweise wie in Figur 1 schematisch gezeigt, innerhalb des Traktionsenergiespeichers 110 angeordnet sein. Alternativ kann die Vorrichtung 150 als eigenständige Baugruppe im Gleichstromnetz 106 angeordnet sein. Ferner kann die Vorrichtung teilweise im Traktionsenergiespeicher 110 integriert sein. Vorteilhafterweise ist der Messanschluss 152 mit einem Gleichspannungspol 113 der Zellmodule 114 unabhängig vom Zustand des Schaltschützes 116 verbunden, beispielsweise zur Bestimmung von Isolationswiderständen bei geöffnetem Schaltschütz 116.

Zur Bestimmung der Isolationswiderstände erfasst die Vorrichtung 150 den Betriebszustand des Stromrichters 120, d.h. einen durch einen zeitlichen Schaltverlauf der Schaltelemente 122 bestimmten Schaltzustand, beispielsweise einen durch einen Tastgrad bestimmten Betriebszustand mindestens eines Schaltelements 122. In mehreren zeitlich getrennten Messintervallen misst die Vorrichtung 150 jeweils den Leitwert zwischen Messanschluss 152 und Masseanschluss 153. Hierbei definiert der Betriebszustand einen für das jeweilige Messintervall stationären und im Allgemeinen (beispielsweise zwischen den Messintervallen) dynamischen Schaltzustand oder Tastgrad. Beispielsweise öffnet und schließt sich das mindestens eine Schaltelement 122 mehrfach (beispielsweise mehr als 100- oder 1000-mal) innerhalb eines Messintervalls gemäß dem Schaltzustand oder Tastgrad.

Die Vorrichtung 150 nutzt den Betriebszustand des Stromrichters 120, d.h. den Schaltzustand oder Tastgrad der das Gleichstromnetz 106 mit dem Wechselstromnetz 108 verbindenden Schaltelemente 122, zur wertrichtigen Bestimmung des Isolationswiderstandes auch in Wechselstromnetzen 108. Der Schaltzustand oder Tastgrad der Schaltelemente 122 kann dabei von einer Erfassungseinrichtung der Vorrichtung 150 zur Bestimmung des Isolationswiderstandes aktiv beeinflusst werden und/oder kann dieser zur Verfügung gestellt werden. Beispielsweise umfasst die Erfassungseinrichtung eine Schnittstelle zum Stromrichter 120 zum Erfassen oder Abfragen des Betriebszustands des Stromrichters 120. Beispielsweise werden über die Schnittstelle Zustandsvorgaben oder Zustandsmeldungen ausgetauscht, z.B. eine Schließstellung oder Offenstellung eines der Schaltelemente 122 oder ein Tastgrad eines Halbleiter-Umrichters als Stromrichter 120.

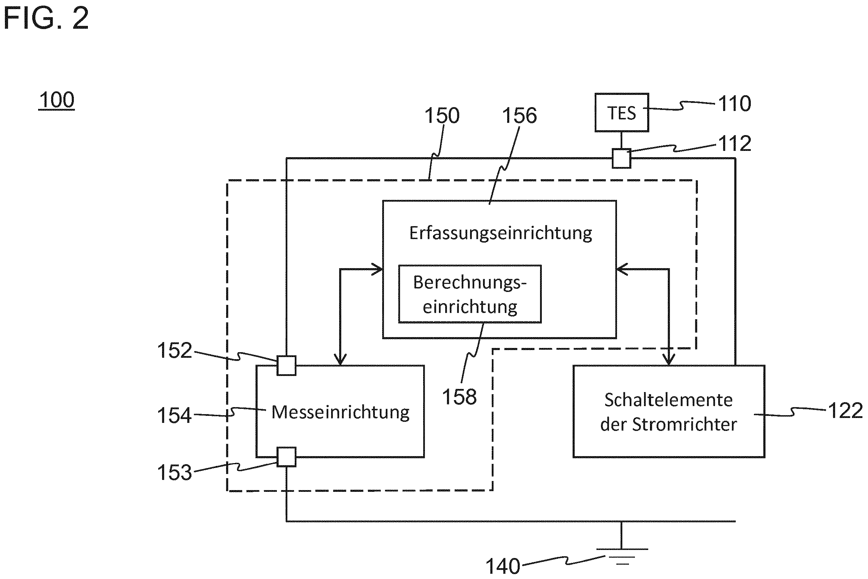

Figur 2 zeigt ein schematisches Blockschaltbild eines zweiten Ausführungsbeispiels der Vorrichtung 150 zur Bestimmung von Isolationswiderständen in einem Kraftfahrzeug 100. Mit dem ersten Ausführungsbeispiel austauschbare oder übereinstimmende Merkmale sind mit gleichen Bezugszeichen versehen.

Die Vorrichtung 150 umfasst eine Erfassungseinrichtung 156, die dazu ausgebildet ist, in mindestens zwei Messintervallen jeweils einen Betriebszustand mindestens eines mit dem Traktionsenergiespeicher 100 leitend verbundenen Stromrichters des Kraftfahrzeugs 100 bzw. dessen Schaltelemente 122 zu erfassen.

Die Vorrichtung 150 umfasst ferner eine Messeinrichtung 154 mit einem Messanschluss 152, der mit mindestens einem Gleichspannungspol 112 eines elektrischen Traktionsenergiespeichers 110 des Kraftfahrzeugs 100 leitend verbunden ist, und einem Masseanschluss 153, der mit einem Bezugspotential 140 des Kraftfahrzeugs 100 leitend verbunden ist. Die Messeinrichtung 154 ist dazu ausgebildet, in den mindestens zwei Messintervallen jeweils mindestens einen Leitwert zwischen dem Messanschluss 152 und dem Masseanschluss 153 zu messen.

Hierzu kann die Messeinrichtung 154 räumlich getrennt von anderen Einrichtungen der Vorrichtung 150 angeordnet sein, beispielsweise innerhalb des Traktionsenergiespeichers 110. Die Erfassungseinrichtung 156 kann als übergeordnete Einrichtung ausgebildet sein, welche die passive Erfassung der Betriebszustände der Stromrichter 120 (beispielsweise der Schaltzustände oder Tastgrade der Schaltelemente 122) mit der Messeinrichtung 154 zur Messung des Leitwerts koordiniert.

Die Vorrichtung 150 umfasst ferner eine Berechnungseinrichtung 158, die dazu ausgebildet ist, die Isolationswiderstände als Funktion der mindestens zwei gemessenen Leitwerte und der mindestens zwei erfassten Betriebszustände zu bestimmen. Die Berechnungseinrichtung 158 kann, wie in Figur 2 gezeigt, Teil der Erfassungseinrichtung 156 sein.

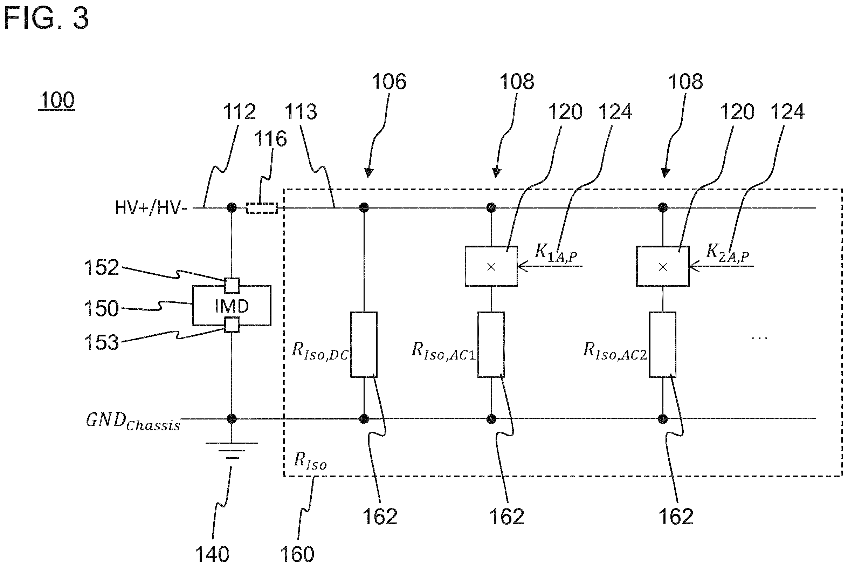

Figur 3 zeigt ein Ersatzschaltbild für das Kraftfahrzeug 100 bezüglich des Isolationswiderstandes 162 (bezeichnet mit $R_{Iso,DC}$) eines Gleichstromnetzes 106 sowie der Isolationswiderstände (bezeichnet mit $R_{Iso,AC1}$ bzw. $R_{Iso,AC2}$) zweier Wechselstromnetze 108. Das Ersatzschaltbild bzw. die entsprechende Berechnung durch die Berechnungseinrichtung 158 kann in jedem Ausführungsbeispiel der Vorrichtung 150 implementiert sein. In jedem Messintervall wird der Leitwert 160 zwischen Messanschluss 152 und Masseanschluss 153 (oder äquivalent dessen Kehrwert als kombinierter Isolationswiderstand) gemessen.

Die Wechselstromnetze 108 sind jeweils über die Schaltelemente 122 des zugehörigen Stromrichters 120 mit dem Gleichstromnetz 106 parallelgeschaltet. Die Ankopplung der Wechselstromnetze 108 über die jeweiligen Stromrichter 120 geht mittels vom Betriebszustand 124 des jeweiligen Stromrichters 120 oder Schaltelements 122 bestimmte Faktoren $K_1$ bzw. $K_2$ in die Bestimmung der Isolationswiderstände ein. Beispielsweise entspricht der Faktor $K_i$ dem Tastgrad des jeweiligen Stromrichters 120 oder Schaltelements 122.

Die Stromrichter 120 können durch eine Leistungselektronik (LE) realisiert sein. Insbesondere können die Stromrichter 120 einen AC-/DC-Umrichter und/oder einen AC-/DC-Wandler umfassen. Die in den mindestens zwei Messintervallen jeweils erfassten Betriebszustände 124 können jeweils einen aktiven Betriebszustand (Index "A") oder passiven Betriebszustand (Index "P") umfassen. Der aktive Betriebszustand kann beispielsweise einen Tastgrad von 50% umfassen, d.h., das angesteuerte Aggregat arbeitet. Der passive Betriebszustand kann beispielsweise einen Tastgrad von 0% oder weniger als 5% umfassen, d.h. das angesteuerte Aggregat arbeitet nicht. Hierbei sind "aktiv" und "passiv" beispielhafte Bezeichnungen für zwei unterschiedliche Betriebszustände.

Werden die Schaltelemente 122 für die Dauer des Messintervalls vollständig geschlossen (z.B. aktiver Kurzschluss der Wechselstromphasen aller Umrichter 120, bei dem dessen drei Wechselstromphasen mit jeweils einem Gleichspannungspol verbunden werden, d.h. es werden entweder nur die oberen oder nur die unteren drei Schaltelemente 122 in Fig. 3 geschlossen, da sonst die beiden Gleichspannungspole ebenfalls kurzgeschlossen würden), ist bereits eine einzelne Messung zur wertrichtigen Bestimmung oder Abschätzung des Isolationswiderstandes des Gesamtnetzes ausreichend. Dabei kann aufgrund der Parallelschaltung bestimmt oder abgeschätzt werden, dass die Isolationswiderstände der einzelnen Phasen (d.h. die Einzelwerte der Teilnetze) alle größer oder gleich dem gemessenen kombinierten Wert des Isolationswiderstands sind. Damit kann die Einhaltung eines Grenzwerts ohne Sicherheitsaufschlag sichergestellt werden. Vorzugsweise wird dabei vorausgesetzt, dass der Widerstand des Umrichters im aktiven Kurzschluss vernachlässigbar ist, d.h. die Näherung wird vorausgesetzt, dass der Kopplungsfaktor = 1 ist. Das Schließen der Schaltelemente 122 wird dabei zeitlich koordiniert mit der Messung durchgeführt.

Die Berechnungseinrichtung 158 bestimmt gemäß der Parallelschaltung der Stromkreise 106 und 108 im jeweiligen Betriebszustand 124 und gemäß des gemessenen Leitwerts 160 die Isolationswiderstände 162. Die Auswirkung des Betriebszustands 124 des Stromrichters 120 bzw. dessen Schaltelemente 122 (z.B. Tastgrad eines Umrichters 120) kann vorab analytisch oder experimentell bestimmt und in der Berechnungseinrichtung 158 hinterlegt werden, z.B. mittels der Faktoren $K_i$ in Abhängigkeit des Tastgrads in einfachster Form oder in Form von linearen oder nichtlinearen Funktionen (beispielsweise einer Reihenentwicklung). Diese Funktionen können, beispielsweise Fahrzeug-spezifisch oder Typen-spezifisch (für ein Serienmodell), vor der Herstellung des Kraftfahrzeugs 100 (beispielsweise in einem Messaufbau anhand bekannter Isolationswiderstände im Wechselstromnetz 108 oder an einem Prototypen des Kraftfahrzeugs 100) ermittelt werden.

Für ein Gesamtnetz mit einem Gleichstromnetz 106 und einem Wechselstromnetz 108 müssen mindestens zwei Messungen des Leitwerts 160, d.h. zwei erfasste Messintervalle, mit mindestens zwei unterschiedlichen Betriebszuständen 124 (beispielsweise Schaltzustände oder Tastgrade der Schaltelemente) durchgeführt werden. Allgemeine können die N Isolationswiderstände von N Wechselstromnetzen 108 und der Isolationswiderstand eines Gleichstromnetzes 106 aufgrund von mindestens N+1 Messungen des Leitwerts 160 in jeweils einem Messintervall mit entsprechend N+1 unterschiedlichen Betriebszuständen bestimmt werden. Falls mehr als N+1 Messungen vorliegen, kann die Berechnungseinrichtung 158 ein lineare Regression durchführen.

Das durch die Erfassungseinrichtung 156 ausgeführte passive Verfahren umfasst das Erfassen oder Abfragen unterschiedlicher Betriebszustände 124 (beispielsweise Schaltzustände oder Tastgrade) der Stromrichter 120 oder deren Schaltelemente 122. Die Betriebsanforderungen an den Stromrichter 120 (bzw. die Betriebsanforderungen an dessen Schaltelemente 122) stören somit nicht die Nutzerfunktionen (z.B. Fahren, Kühlen, Lenkunterstützung).

Beispielsweise ändern sich die Betriebszustände 124 aufgrund der Betriebsanforderungen (z.B. einer Leistungsanforderung für die Wechselstrommaschine), insbesondere durch zeitvariable Ansteuerung des Tastgrads des Stromrichters 120 für den Fahrantrieb (je nach Fahrerwunschmoment), eines Stromrichters 120 für die Lenkunterstützung (je nach Lenkeinschlag), eines Stromrichters 120 für den Klimakompressor (je nach Kühlbedarf). Die Erfassungseinrichtung 156 erfasst die Betriebsanforderung und bestimmt auf dieser Grundlage das Messintervall und die Betriebszustände 124. Beispielsweise kann in der Betriebsanforderung ein vorausbestimmter Verlauf der Betriebszustände 124 enthalten sein. Vorzugsweise bestimmt die Erfassungseinrichtung das Messintervall in einer Phase zeitlich konstanter Betriebszustände. Alternativ oder in Kombination mit teilweise zeitkonstanten betriebszuständen 124 werden zeitveränderliche Betriebszustände 124 über das Messintervall gemittelt. Dies erleichtert die wertrichtige Bestimmung des Leitwerts 160 bzw. des entsprechenden kombinierten Isolationswiderstandes.

Alternativ oder ergänzend ist die Dauer des Messintervalls (z.B. 500 ms bis 30 s) von der Variabilität des erfassten Betriebszustands 124 abhängig. Eine Mindestdauer der Messintervalle, d.h. der Messdauern, kann sich aufgrund Ableitkapazitäten des IT-Netzes und/oder einer (von der Messeinrichtung 154 ausgeführten) Filterung ergeben.

Sind mindestens zwei Messwerte des Leitwerts 160 (beispielsweise des kombinierten Isolationswiderstands) und jeweils der (ggf. gemittelte) Betriebszustand 124 (beispielsweise die zugehörige funktionale Abhängigkeit des Isolationswiderstands 162 beim jeweiligen Betriebszustand 124 oder die Werte der Faktoren $K_i$ in Abhängigkeit des Betriebszustands 124) bekannt, bestimmt die Berechnungseinrichtung 158 die unbekannten Größen 162 des Isolationswiderstands $R_{Iso,DC}$ im Gleichstromnetz 106 und des jeweiligen Isolationswiderstands $R_{Iso,ACi}$ im i-ten Wechselstromnetz 108, beispielsweise mittels Regression. Grundsätzlich ist durch die Berechnungseinrichtung 158 die Bestimmung aller Isolationswiderstände 162 ermöglicht, wenn die Anzahl der Messungen (d.h. der Messintervalle) größer oder gleich der Anzahl der Teilnetze 106 und 108 ist.

Beispielsweise berechnet die Berechnungseinrichtung 158 die Isolationswiderstände 162 aufgrund der gemessenen Leitwerte 160 $L_i$ (bzw. der kombinierten Isolationswiderstände $R_{Iso,i}=1/L_i$) und den jeweiligen Kopplungsfaktoren $K_i$ der Betriebszustände 124 wie folgt.

Aufgrund von beispielsweise N+1=3 Messintervallen sind die Datensätze $(R_{Iso,1}, K_{1P}, K_{2P})$, $(R_{Iso,2}, K_{1A}, K_{2P})$, $(R_{Iso,3}, K_{1A}, K_{2A})$ bekannt. Berechnet werden die Isolationswiderstände 162, d.h. $R_{Iso,DC}$, $R_{Iso,AC1}$, $R_{Iso,AC2}$, der jeweiligen Stromnetze 106 und 108. Genauer bestimmt die Berechnungseinrichtung 158 die Isolationswiderstände 162 als Funktion der Datensätze aufgrund der funktionalen Abhängigkeiten im jeweiligen Messintervall:

$$\text{Messintervall 1: } R_{Iso,1} = R_{Iso,DC} \, || \, K_{1P} \quad R_{Iso,AC1} \, || \, K_{2P} \quad R_{Iso,AC2} \, || \, \ldots$$

$$\text{Messintervall 2: } R_{Iso,2} = R_{Iso,DC} \, || \, K_{1A} \quad R_{Iso,AC1} \, || \, K_{2P} \quad R_{Iso,AC2} \, || \, \ldots$$

$$\text{Messintervall 3: } R_{Iso,3} = R_{Iso,DC} \, || \, K_{1A} \quad R_{Iso,AC1} \, || \, K_{2A} \quad R_{Iso,AC2} \, || \, \ldots$$

Dabei bezeichnet "||" die elektrische Parallelschaltung von Widerständen, d.h., die Summe der Kehrwehrte der Widerstände. Liegen der Berechnungseinrichtung 158 die Datensätze von N+1 Messintervallen vor, können (bei disjunkten erfassten Betriebszuständen) alle Isolationswiderstände 162 berechnet werden, beispielsweise durch Inversion einer durch die Kopplungsfaktoren bestimmten Matrix. Liegen Datensätze von mehr als N+1 Messintervallen vor, werden die Isolationswiderstände 162 durch Regression bestimmt.

Beispielsweise werden die Isolationswiderstände wie folgt berechnet.

$$\text{Messintervall 1: } R_{Iso,1} = 1 \, / \, (1/R_{Iso,DC} + 1/(K_{1P} \cdot R_{Iso,AC1}) + 1/(K_{2P} \cdot R_{Iso,AC2}) + \ldots)$$

$$\text{Messintervall 2: } R_{Iso,2} = 1 \, / \, (1/R_{Iso,DC} + 1/(K_{1A} \cdot R_{Iso,AC1}) + 1/(K_{2P} \cdot R_{Iso,AC2}) + \ldots)$$

$$\text{Messintervall 3: } R_{Iso,2} = 1 \, / \, (1/R_{Iso,DC} + 1/(K_{1A} \cdot R_{Iso,AC1}) + 1/(K_{2A} \cdot R_{Iso,AC2}) + \ldots)$$

Alternativ können reziproke Kopplungsfaktoren (beispielsweise bei einer Berechnung mittels der Leitwerte) verwendet werden:

$$\text{Messintervall 1: } G_{Iso,1} = G_{Iso,DC} + K_{1P} \cdot G_{Iso,AC1} + K_{2P} \cdot G_{Iso,AC2} + \ldots$$

$$\text{Messintervall 2: } G_{Iso,2} = G_{Iso,DC} + K_{1A} \cdot G_{Iso,AC1} + K_{2P} \cdot G_{Iso,AC2} + \ldots$$

$$\text{Messintervall 3: } G_{Iso,2} = G_{Iso,DC} + K_{1A} \cdot G_{Iso,AC1} + K_{2A} \cdot G_{Iso,AC2} + \ldots$$

Die Technik skaliert auf mehr als ein Wechselstromnetz 108 (beispielsweise mehrere Wechselstrommaschinen, z.B. Fahrantriebe und/oder Nebenaggregate), wodurch nur die Anzahl der erforderlichen (mindestens N+1) Messintervalle mit jeweils unterschiedlichen Betriebszuständen 124 steigt, um alle Isolationswiderstände 162 im Gesamtnetz durch die Vorrichtung 150 zu bestimmen.

Während vorstehend zwischen Stromrichtern 120 jeweils in Zuordnung zu einem Wechselstromnetz 108 und dessen Schaltelementen 122 jeweils in Zuordnung zu einer Phase des Wechselstromnetzes 108 unterschieden wurde, kann die Vorrichtung 150 auch zur Bestimmung der Isolationswiderstände der einzelnen Phasen angewandt werden. Dabei kann die Näherung

Lastwiderstand << Isolationswiderstand

verwendet werden. In diesem Fall können die Begriffe Stromrichter 120 und Schaltelemente 122 austauschbar sein.

Wie anhand vorstehender exemplarischer Ausführungsbeispiele dem Fachmann ersichtlich ist, kann die Technik eine kostengünstige Bestimmung von Isolationswiderständen in gekoppelten Stromnetzen eines Kraftfahrzeugs im Betrieb ermöglichen.

Die Technik kann ein kostengünstiges, passives Messverfahren zur wertrichtigen Bestimmung des Isolationswiderstands in angekoppelten Wechselstromnetzen implementieren. Dagegen ist im Stand der Technik dafür bisher ein deutlich kostenintensiveres, aktives Messverfahren mit einer auf die Netzspannung modulierten Prüfspannung erforderlich.

Ausführungsbeispiele der Technik können einzelne Isolationswiderstandswerte jeweils pro Teilnetz (insbesondere je Gleich- und Wechselstromnetz) bestimmen. Somit kann auch vorteilhaft der Ort eines Isolationsfehlers mit der Technik bestimmt werden. Dies erleichtert die Fehlersuche und Fehlerbehebung.

Das gezielte, passive Erfassen von während der Messintervalle jeweils konstanten Betriebszuständen (beispielsweise Schaltzuständen oder Tastgraden) ermöglicht die wertrichtige Messungen und/oder verbessert die Messgenauigkeit der wertrichtigen Messungen des Isolationswiderstands.

Der Betrieb der Gleich- und Wechselstromnetze (z.B. für die Nutzfunktion Fahren eines Elektrofahrzeugs) kann durch das Verfahren unbeeinflusst bleiben, insbesondere indem die Messintervalle vor und/oder nach der Betriebsphase stattfinden.

Obwohl die Erfindung in Bezug auf exemplarische Ausführungsbeispiele beschrieben worden ist, ist es für einen Fachmann ersichtlich, dass verschiedene Änderungen vorgenommen werden können und Äquivalente als Ersatz verwendet werden können. Ferner können viele Modifikationen vorgenommen werden, um eine bestimmte Situation oder ein bestimmtes Fahrzeugmodell an die Lehre der Erfindung anzupassen. Folglich ist die Erfindung nicht auf die offenbarten Ausführungsbeispiele beschränkt, sondern umfasst alle Ausführungsbeispiele, die in den Bereich der beigefügten Patentansprüche fallen.

**Bezugszeichenliste**

| | |
|---|---|
| 100 | Kraftfahrzeug |
| 102 | Speicherseitiger Bereich |
| 104 | Fahrzeugseitiger Bereich |
| 106 | Gleichstromnetz |
| 108 | Wechselstromnetz |
| 110 | Traktionsenergiespeicher |
| 112, 113 | Gleichspannungspol |
| 114 | Zellmodule |
| 116 | Schaltschütz |
| 118 | Zwischenkreis |
| 120 | Stromrichter |
| 122 | Schaltelement des Stromrichters |
| 124 | Betriebszustand des Stromrichters |
| 130 | Aggregat |
| 132 | Phasen des Aggregats |
| 140 | Bezugspotential des Kraftfahrzeugs |
| 150 | Vorrichtung zur Bestimmung von Isolationswiderständen |
| 152 | Messanschluss |

| 153 | Masseanschluss |
| 154 | Messeinrichtung |
| 156 | Erfassungseinrichtung |
| 158 | Berechnungseinrichtung |
| 160 | Leitwert |
| 162 | Isolationswiderstand |

**Patentansprüche**

1. Vorrichtung (150) zur Bestimmung von Isolationswiderständen (162) von Stromnetzen (106, 108) gegenüber einer elektrischen Masse (140) eines Kraftfahrzeugs (100), die miteinander durch mindestens einen Stromrichter (120) gekoppelt sind, wobei der mindestens eine Stromrichter (120) einen Wechselrichter und/oder einen Gleichspannungswandler umfasst, die Vorrichtung (150) umfassend:

   eine Erfassungseinrichtung (156), die dazu ausgebildet ist, in mindestens zwei Messintervallen jeweils einen Betriebszustand (124) des mindestens einen mit einem Traktionsenergiespeicher (110) leitend verbundenen Stromrichters (120) des Kraftfahrzeugs (100) zu erfassen;
   eine Messeinrichtung (154) mit einem Messanschluss (152), der mit mindestens einem Gleichspannungspol (112) des elektrischen Traktionsenergiespeichers (110) des Kraftfahrzeugs (100) leitend verbunden oder verbindbar ist, und mit einem Masseanschluss (153), der mit einem Bezugspotential (140) des Kraftfahrzeugs (100) leitend verbunden oder verbindbar ist, wobei die Messeinrichtung (154) dazu ausgebildet ist, in den mindestens zwei Messintervallen jeweils einen Leitwert (160) zwischen dem Messanschluss (152) und dem Masseanschluss (153) zu messen; und
   eine Berechnungseinrichtung (158), die dazu ausgebildet ist, die Isolationswiderstände (162) als Funktion der mindestens zwei gemessenen Leitwerte (160) und der mindestens zwei erfassten Betriebszustände (124) zu bestimmen,
   wobei der Betriebszustand einen Tastgrad mindestens eines Schaltelementes (122) des Stromrichters (120) umfasst,
   wobei die Erfassungseinrichtung (156), dazu ausgebildet ist, die Betriebszustände (124) mehrerer Stromrichter (120) jeweils in mehreren Messintervallen zu erfassen, die Messeinrichtung (154) dazu ausgebildet ist, in jedem der Messintervalle den Leitwert (160) zu messen, und die Berechnungseinrichtung (158) dazu ausgebildet ist, für jeden der Stromrichter (120) einen Isolationswiderstand (162) aufgrund der gemessenen Leitwerte (160), der erfassten Betriebszustände (124) und einer Anzahl der Messintervalle, die größer oder gleich der Anzahl der Stromnetze ist, zu berechnen.

2. Vorrichtung nach Anspruch 1, wobei der Betriebszustand einen Schaltzustand mindestens eines Schaltelementes (122) des Stromrichters (120) umfasst.

3. Vorrichtung nach Anspruch 2, wobei der bestimmte Isolationswiderstand (162) eine streng monoton fallende Funktion des Tastgrads ist.

4. Vorrichtung nach Anspruch 2 oder 3, wobei der erfasste Tastgrad unter 100% und/oder über 10% ist.

5. Vorrichtung nach einem der Ansprüche 1 bis 4, wobei die Erfassungseinrichtung ferner dazu ausgebildet ist, für jeden der erfassten Betriebszustände (124) im jeweiligen Messintervall einen mittleren Betriebszustand zu bestimmen.

6. Vorrichtung nach einem der Ansprüche 1 bis 5, wobei der mindestens eine Stromrichter (120) jeweils ein Aggregat (130) des Kraftfahrzeugs (100) speist.

7. Vorrichtung nach einem der Ansprüche 1 bis 6, wobei das Bezugspotential (140) eine elektrisch leitende Karosserie des Kraftfahrzeugs (100) umfasst.

8. Vorrichtung nach einem der Ansprüche 1 bis 7, wobei die Funktion Parameter zur Gewichtung einer Abhängigkeit des Isolationswiderstands vom erfassten Betriebszustand umfasst, und wobei die Berechnungseinrichtung (158) einen Speicher umfasst, in dem Kraftfahrzeug-spezifische Werte der Parameter gespeichert sind.

9. Vorrichtung nach einem der Ansprüche 1 bis 8, wobei die Funktion Parameter zur Gewichtung einer linearen Abhängigkeit und/oder einer nichtlinearen Abhängigkeit des Isolationswiderstands vom erfassten Betriebszustand umfasst.

10. Vorrichtung nach einem der Ansprüche 1 bis 9, wobei die Erfassungseinrichtung (156) die Messintervalle abhängig von einem Fahrzustand des Kraftfahrzeugs (100) bestimmt.

11. Vorrichtung nach Anspruch 10, wobei die Erfassungseinrichtung (156) mindestens ein Messintervall bestimmt, in dem mindestens einer der Betriebszustände zeitlich konstant ist.

12. Kraftfahrzeug (100), insbesondere eine Nutzfahrzeug, umfassend:

einen elektrischen Traktionsenergiespeicher (110);
mindestens einen mit dem Traktionsenergiespeicher (110) leitend verbundenen Stromrichter (120); und
eine Vorrichtung (150) zur Bestimmung von Isolationswiderständen (162) im Kraftfahrzeug (100) gemäß einem der Ansprüche 1 bis 11.

**Claims**

1. A device (150) for determining insulation resistances (162) of power networks (106, 108) with respect to an electrical earth (140) in a motor vehicle (100), which power networks are coupled to one another by way of at least one power converter (120), wherein the at least one power converter (120) comprises an inverter and/or a DC-DC converter, the device (150) comprising:

a detection device (156), which is designed, in at least two measuring intervals, to detect a respective operating state (124) of the at least one power converter (120) of the motor vehicle (100), which power converter is conductively connected to a traction energy store (110);
a measuring device (154) with a measuring terminal (152), which is conductively connected or connectable to at least one DC voltage pole (112) of the electric traction energy store (110) of the motor vehicle (100), and with an earth terminal (153), which is conductively connected or connectable to a reference potential (140) of the motor vehicle (100), wherein the measuring device (154) is designed, in the at least two measuring intervals, to respectively measure a conductance (160) between the measuring terminal (152) and the earth terminal (153); and
a calculation device (158), which is designed to determine the insulation resistances (162) as a function of the at least two measured conductances (160) and the at least two operating states (124) detected,
wherein the operating state comprises a duty cycle of at least one switching element (122) of the power converter (120),
wherein the detection device (156) is designed to detect the operating states (124) of several power converters (120) respectively in several measuring intervals, the measuring device (154) is designed to measure the conductance (160) in each of the measuring intervals, and the calculation device (158) is designed to calculate for each of the power converters (120) an insulation resistance (162) based on the measured conductances (160), the operating states (124) detected and a number of measuring intervals, which is greater than or equal to the number of power networks.

2. The device according to Claim 1, wherein the operating state comprises a switching state of at least one switching element (122) of the power converter (120).

3. The device according to Claim 2, wherein the insulation resistance (162) determined is a strictly monotonically declining function of the duty factor.

4. The device according to Claim 2 or 3, wherein the duty factor detected is less than 100% and/or greater than 10%.

5. The device according to one of Claims 1 to 4, wherein the detection device is also designed to determine an average operating state for each of the detected operating states (124) in the respective measuring interval.

6. The device according to one of Claims 1 to 5, wherein the at least one power converter (120) respectively supplies a unit (130) of the motor vehicle (100).

7. The device according to one of Claims 1 to 6, wherein the reference potential (140) is constituted by an electrically conductive bodywork of the motor vehicle (100).

8. The device according to one of Claims 1 to 7, wherein the function incorporates parameters for the weighting of a dependence of the insulation resistance on the operating state detected, and wherein the calculation device (158) incorporates a memory, in which motor vehicle-specific parameter values are stored.

9. The device according to one of Claims 1 to 8, wherein the function incorporates parameters for the weighting of a linear dependence and/or a non-linear dependence of the insulation resistance on the operating state detected.

10. The device according to one of Claims 1 to 9, wherein the detection device (156) determines the measuring intervals as a function of a driving state of the motor vehicle (100).

11. The device according to Claim 10, wherein the detection device (156) determines at least one measuring interval in which at least one of the operating states is temporally constant.

12. A motor vehicle (100), in particular a utility vehicle, comprising:

an electric traction energy store (110);
at least one power converter (120) which is conductively connected to the traction energy store (110); and
a device (150) for determining insulation resistances (162) in the motor vehicle (100) according to one of Claims 1 to 11.

**Revendications**

1. Dispositif (150) permettant de déterminer des résistances d'isolement (162) de réseaux électriques (106, 108) par rapport à une masse électrique (140) d'un véhicule automobile (100) qui sont couplées les unes aux autres par au moins un convertisseur de courant (120), ledit au moins un convertisseur de courant (120) comprenant un onduleur et/ou un convertisseur continu-continu, le dispositif (150) comprenant :

un moyen de détection (156) qui est réalisé pour détecter dans au moins deux intervalles de mesure respectivement un état de fonctionnement (124) dudit au moins un convertisseur de courant (120) du véhicule automobile (100), relié en conduction à un accumulateur d'énergie de traction (110) ;
un moyen de mesure (154) pourvu d'une borne de mesure (152) qui est reliée ou peut être reliée en conduction à au moins un pôle de tension continue (112) de l'accumulateur d'énergie de traction électrique (110) du véhicule automobile (100), et d'une borne de masse (153) qui est reliée ou peut être reliée en conduction à un potentiel de référence (140) du véhicule automobile (100), le moyen de mesure (154) étant réalisé pour mesurer dans les au moins deux intervalles de mesure respectivement une conductance (160) entre la borne de mesure (152) et la borne de masse (153) ; et
un moyen de calcul (158) qui est réalisé pour déterminer les résistances d'isolement (162) en fonction des au moins deux conductances (160) mesurées et des au moins deux états de fonctionnement (124) détectés, l'état de fonctionnement comprenant un rapport cyclique d'au moins un élément de commutation (122) du convertisseur de courant (120),
le moyen de détection (156) étant réalisé pour détecter les états de fonctionnement (124) de plusieurs convertisseurs de courant (120) respectivement dans plusieurs intervalles de mesure, le moyen de mesure (154) étant réalisé pour mesurer la conductance (160) dans chacun des intervalles de mesure, et le moyen de calcul (158) étant réalisé pour calculer pour chacun des convertisseurs de courant (120) une résistance d'isolement (162) sur la base des conductances (160) mesurées, des états de fonctionnement (124) détectés et d'un nombre des intervalles de mesure qui est supérieur ou égal au nombre des réseaux électriques.

2. Dispositif selon la revendication 1, dans lequel l'état de fonctionnement comprend un état de commutation d'au moins un élément de commutation (122) du convertisseur de courant (120).

3. Dispositif selon la revendication 2, dans lequel la résistance d'isolement (162) déterminée est une fonction décroissante de manière strictement monotone du rapport cyclique.

4. Dispositif selon la revendication 2 ou 3, dans lequel le rapport cyclique détecté est inférieur à 100 % et/ou supérieur à 10 %.

5. Dispositif selon l'une quelconque des revendications 1 à 4, dans lequel le moyen de détection est en outre réalisé pour déterminer un état de fonctionnement moyen pour chacun des états de fonctionnement (124) détectés dans l'intervalle de mesure respectif.

6. Dispositif selon l'une quelconque des revendications 1 à 5, dans lequel ledit au moins un convertisseur de courant (120) alimente respectivement un groupe (130) du véhicule automobile (100).

7. Dispositif selon l'une quelconque des revendications 1 à 6, dans lequel le potentiel de référence (140) comprend une carrosserie électriquement conductrice du véhicule automobile (100).

8. Dispositif selon l'une quelconque des revendications 1 à 7, dans lequel la fonction comprend des paramètres pour pondérer une dépendance de la résistance d'isolement de l'état de fonctionnement détecté, et le moyen de calcul (158) comprend une mémoire dans laquelle sont stockées des valeurs des paramètres, spécifiques au véhicule automobile.

9. Dispositif selon l'une quelconque des revendications 1 à 8, dans lequel la fonction comprend des paramètres pour pondérer une dépendance linéaire et/ou une dépendance non linéaire de la résistance d'isolement de l'état de fonctionnement détecté.

10. Dispositif selon l'une quelconque des revendications 1 à 9, dans lequel le moyen de détection (156) détermine les intervalles de mesure en fonction d'un état de conduite du véhicule automobile (100).

11. Dispositif selon la revendication 10, dans lequel le moyen de détection (156) détermine au moins un intervalle de mesure dans lequel au moins l'un des états de fonctionnement est constant dans le temps.

12. Véhicule automobile (100), en particulier véhicule utilitaire, comprenant :

un accumulateur d'énergie de traction électrique (110) ;
au moins un convertisseur de courant (120) relié en conduction à l'accumulateur d'énergie de traction (110) ; et
un dispositif (150) permettant de déterminer des résistances d'isolement (162) dans le véhicule automobile (100) selon l'une quelconque des revendications 1 à 11.

FIG. 1

# FIG. 2

<u>100</u>

TES —110

112

150    156

Erfassungseinrichtung

Berechnungseinrichtung

152

154 — Messeinrichtung

158

153

Schaltelemente
der Stromrichter —122

140

EP 3 366 506 B1

14

FIG. 3

EP 3 366 506 B1

**EP 3 366 506 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1930737 A1
- US 2016163127 A1
- US 2016181965 A1
- DE 102010054413 A1